# DEMANDE DE BREVET EUROPEEN

(11) **EP 2 254 161 A2**
(43) Date de publication de la demande: **24.11.2010**
(21) Numéro de dépôt: 10162979.8
(22) Date de dépôt: 17.05.2010
(51) Int. Cl.: H01L 31/102, H01L 27/146

(54) **Photodiode a controle de charge d'interface et procede associe.**

(30) Priorité: 18.05.2009 FR 0953288
(71) Demandeur: STmicroelectronics SA, 92120 Montrouge (FR); STMicroelectronics (Crolles 2) SAS, 38920 Crolles (FR)
(72) Inventeur: Regolini, Jorge, 38190, BERNIN (FR); Gros-Jean, Michael, 38000, GRENOBLE (FR)
(74) Mandataire: Delprat, Olivier

(57) **Abrégé**

Photodiode comprenant une première couche dopée (2) et une deuxième couche dopée (3) présentant une face commune, au moins une tranchée d'isolation profonde (4) présentant une face contiguë avec la première couche dopée (2) et la deuxième couche dopée (3), une face libre de la deuxième couche dopée (3) étant en contact avec une couche conductrice (5),
**caractérisée en ce qu**'elle comprend une couche de protection (7) apte à générer une couche de charges négatives à l'interface avec la première couche dopée (2) et la deuxième couche dopée (3).

## Description

L'invention se rapporte au domaine des photodiodes et plus particulièrement aux photodiodes réalisées en matrices.

La technologie des photodiodes repose sur deux paramètres importants.

Le premier paramètre est la sensibilité de la photodiode qui représente la capacité de la photodiode à collecter des porteurs de charge photogénérés. Ce paramètre contrôle l'intensité du courant généré pour une illumination donnée.

Le deuxième paramètre est le courant d'obscurité qui représente le courant circulant dans la photodiode lorsque aucune lumière ne l'illumine. Ce paramètre contrôle la différence d'intensité du courant généré pour une différence d'illumination donnée.

Une partie plus ou moins importante des électrons générés dans la photodiode ne participent pas au photocourant car ils sont piégés par des défauts structuraux ou des zones de recombinaison.

Dans le cas des capteurs matriciels à photodiodes, des tranchées d'isolation profonde sont employées afin de limiter les effets de voisinage. Cependant, les tranchées d'isolation profonde peuvent jouer un rôle similaire aux défauts structuraux ou centres de recombinaison. En effet, les tranchées d'isolation profonde comprennent généralement un matériau isolant et sont réalisées dans un milieu semi-conducteur. Par ailleurs, une propriété inhérente aux interfaces Silicium/oxyde ou silicium/nitrure est de présenter une charge de surface positive apte à attirer les électrons photogénérés. On comprend alors que les tranchées d'isolation profonde agissent comme des pièges pour les électrons photogénérés.

Il existe un certain nombre de travaux traitant des problèmes d'interface entre isolant et semiconducteur, particulièrement dans des structures comparables aux photodiodes. On s'intéressera aux documents suivants pour illustrer l'état de la technique.

Le document « SiN/SiC :H passivation layers for p and n type Si wafers », U. Coscia et al.,Thin Solid Films 516 (2008) 1569 décrit les effets de charges de surface de certains matériaux utilisés pour la passivation en microélectronique. Sont notamment citées les structures Al/SiNₓ/Si, Al/a-SiCₓ :H/Si et Al/SiNₓ /a-SiCₓ :H/Si.

Comme on peut le voir, les tranchées d'isolation profonde peuvent présenter des effets de recombinaison entre les électrons photogénérés et les charges à l'interface entre les tranchées d'isolation profonde et le silicium dans une photodiode.

Le document « Development of robust interfaces based on crystalline γ-Al2O3(001) for subsequent deposition of amorphous high-κ oxides» Merckling, C. et al., Microelectronics Engineering, v 84 (2007) 2243-6 décrit des procédés de croissance de structures en γ-Al₂O₃ cristallin destinées à une croissance ultérieure d'oxydes à fort κ.

Le document « Evidence of a high density of fixed negative chages in an insulation layer compound of SI », D. Konig et al., Thin Solid Films 285 (2001) 126 décrit la formation d'une structure apte à générer un effet de polarisation négatif dans une structure en silicium. En particulier, il est évoqué l'effet de l'association d'une couche d'alliage de aluminiumfluoride-dioxyde de silicium sur du silicium qui permet de faire apparaître des charges négatives à l'interface entre les deux couches de matériaux.

On voit ainsi qu'il existe des matériaux aptes à créer une couche de charge négative à l'interface avec du silicium.

Il existe donc un besoin pour disposer d'un procédé de réalisation permettant de minimiser ou de supprimer le piégeage des électrons photogénérés au voisinage des murs d'isolation profonde.

Il existe également un besoin pour un dispositif de type photodiode dans lequel le piégeage des électrons photogénérés au voisinage des murs d'isolation profonde est minimisé ou supprimé.

Il est donc proposé, selon un premier aspect, une photodiode comprenant une première couche dopée et une deuxième couche dopée présentant une face commune, au moins une tranchée d'isolation profonde présentant une face contiguë avec la première couche dopée et la deuxième couche dopée, une face libre de la deuxième couche dopée étant en contact avec une couche conductrice. La photodiode ainsi définie comprend au moins une tranchée d'isolation profonde étant munie sur sa surface, d'une couche de protection apte à générer une couche de charges négatives à l'interface avec d'une part la première couche dopée et la deuxième couche dopée et d'autre part la tranchée d'isolation profonde.

La photodiode peut comprendre par ailleurs une couche intermédiaire de protection située au moins en partie dans la deuxième couche dopée, ladite couche intermédiaire de protection étant apte à générer une couche de charges négatives à l'interface avec la deuxième couche dopée.

L'épaisseur de la couche intermédiaire de protection peut être comprise entre 5nm et 20nm.

La couche intermédiaire de protection peut être réalisée dans un matériau choisi parmi AlF₃, SiN/SiC, Al₂O₃, HfAlₓO_{y}/SiO₂, AlN avec une implantation de F et ZrO₂.

L'épaisseur de la couche de protection peut être comprise entre 5nm et 20nm.

La couche de protection peut être réalisée dans un matériau choisi parmi AlF₃, SiN/SiC, Al₂O₃, HfAlₓO_{y}/SiO₂, AlN avec une implantation de F et ZrO₂.

Selon un autre aspect de l'invention, il est proposé un procédé de réalisation d'au moins une tranchée d'isolation profonde, chaque tranchée d'isolation profonde étant réalisée entre deux photodiodes réalisées à partir d'une structure comprenant une première couche dopée et une deuxième couche dopée présentant une face commune, l'autre face de la deuxième couche dopée étant en contact avec une couche conductrice. Ce procédé comprend les étapes au cours desquelles :
- on réalise une gravure d'au moins une tranchée à travers la première couche dopée et la deuxième couche dopée jusqu'à la couche conductrice;
- on dépose de façon conforme, dans la tranchée, une couche de protection d'un matériau apte à créer une couche de charge négative à l'interface avec le silicium ; et
- on dépose un isolant de façon conforme sur la couche de protection jusqu'à remplissage de la tranchée.

On peut réaliser la couche de protection avec une épaisseur comprise entre 5nm et 20nm.

On peut réaliser la couche de protection dans un matériau choisi parmi AlF₃, SiN/SiC, Al₂O₃, HfAlₓO_{y}/SiO₂, AlN avec une implantation de F et ZrO₂.

D'autres buts, caractéristiques et avantages apparaîtront à la lecture de la description suivante donnée uniquement en tant qu'exemple non limitatif et faite en référence aux dessins annexés sur lesquels :
- la figure 1 illustre les principaux éléments d'une photodiode selon l'état de l' art ;
- la figure 2 illustre les principaux éléments d'une photodiode selon un premier mode de réalisation ;
- la figure 3 illustre les principaux éléments d'une photodiode selon un deuxième mode de réalisation ; et

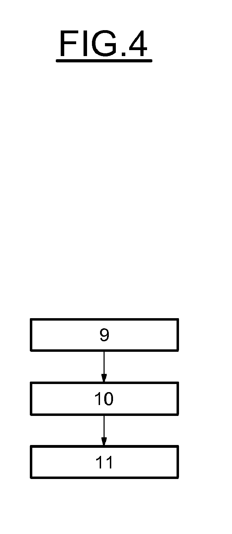

- la figure 4 illustre les principales étapes d'un procédé de fabrication d'une photodiode.

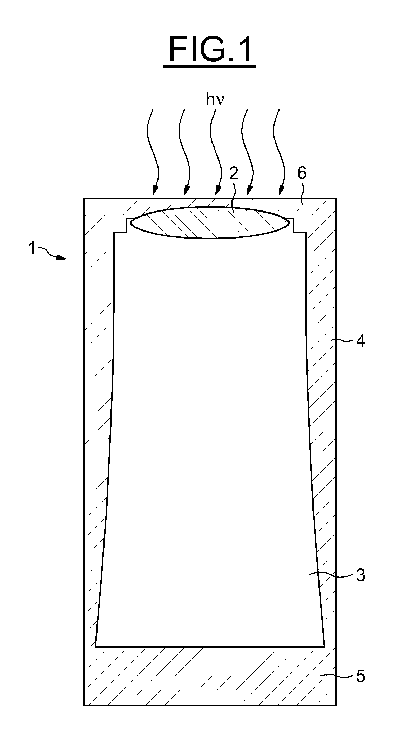

Sur la figure 1, on peut voir une photodiode selon l'état de l'art. La photodiode 1 comprend une ouverture sur un empilement de deux couches de dopages opposés, formant une diode. Une première couche 2 présente un dopage N tandis que la deuxième couche 3 présente un dopage P. Sous la deuxième couche 3 se situe une zone conductrice 5, pouvant être une couche de silicium, une couche de silicium dopé, ou une couche métallique.

La photodiode 1 ainsi décrite est généralement destinée à être intégrée dans un capteur matriciel. Il est alors nécessaire d'isoler une photodiode donnée des photodiodes voisines. Pour cela, des tranchées d'isolation profonde 4 sont formées pour séparer deux photodiodes immédiatement voisines. Les tranchées d'isolation profonde 4 (DTI ou « Deep trench isolation » en anglais) sont réalisées en matériau isolant.

Par ailleurs, la face extérieure de la photodiode se trouve protégée de l'extérieur par une couche de passivation 6, également en matériau isolant.

A l'interface entre la première couche 2 et la deuxième couche 3 se crée une zone de charge d'espace dans laquelle le rayonnement électromagnétique incident peut être absorbé. L'absorption donne lieu alors à la création d'une paire électron-trou. L'électron et le trou migrent chacun dans une direction opposée sous l'effet du champ électrique régnant dans la zone de charge d'espace. Le déplacement des électrons et des trous photogénérés donne ainsi lieu à la création d'un courant photoélectrique.

Comme cela a été décrit précédemment, les tranchées d'isolation profonde 4 sont généralement réalisées en isolant de type oxyde ou nitrure qui présentent la propriété de générer une charge positive à l'interface avec un semi-conducteur. Dans le cas de la photodiode décrite sur la figure 1, une telle couche de charge positive peut engendrer un champ suffisant pour attirer et capturer les électrons photogénérés, diminuant d'autant le courant photoélectrique.

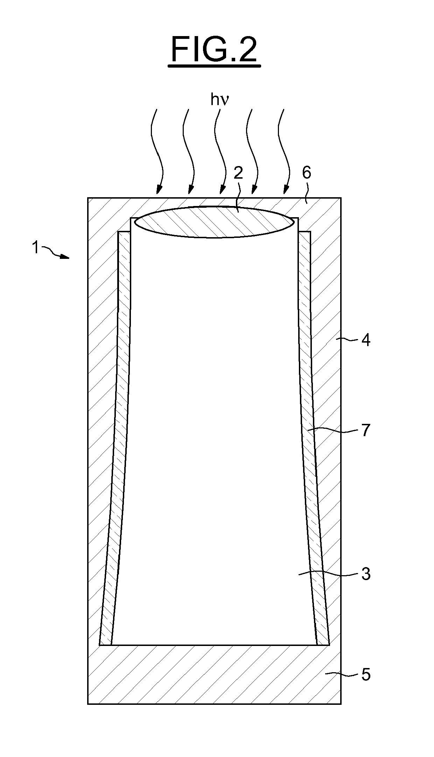

Un premier mode de réalisation, illustré par la figure 2 comprend une couche de protection 7. Cette couche de protection permet de créer une couche de charges négatives à l'interface avec la première couche 2 et la deuxième couche 3 afin de repousser les électrons photogénérés et de diminuer les risques de capture.

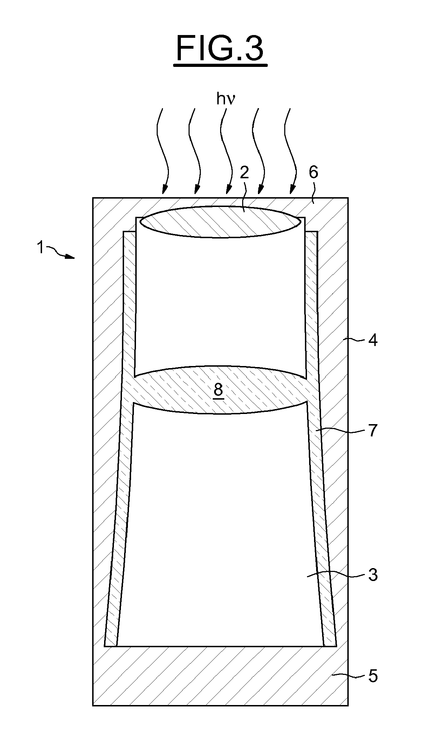

Un deuxième mode de réalisation est illustré par la figure 3. Le deuxième mode de réalisation comprend l'élaboration d'une couche 8 de protection intermédiaire réalisée dans un matériau similaire au matériau employé dans la réalisation des couches de protection 7. Une telle couche présente plusieurs effets bénéfiques sur les performances de la photodiode.

Un premier effet est de réduire l'extension de la zone de charge d'espace sans en réduire la différence de potentiel. Cela a pour effet d'augmenter le champ électrique auquel sont soumises les paires électron-trou photogénérées. Le temps de transit des électrons et des trous photogènes est ainsi réduit, le temps de réponse de la photodiode est amélioré.

Un deuxieme effet est d'agir en tant que piège pour les trous photogénérés permettant ainsi d'augmenter la sensibilité de la photodiode et de réduire le courant d'obscurité de la photodiode.

Cependant, ce deuxième mode de réalisation est dépendant de la profondeur à laquelle la couche 8 de protection intermédiaire doit être implantée. Plus la longueur d'onde de l'onde incidente est courte, plus l'effet photoélectrique à lieu près de la couche active. Cela implique que plus la longueur d'onde est courte, plus on peut créer une couche 8 de protection intermédiaire proche de la zone active. En pratique, le deuxième mode de réalisation est restreint aux photodiodes correspondant aux pixels bleus dans un système rouge, vert, bleu.

La couche de protection 7 sont réalisées avec une épaisseur comprise entre 5 et 20nm.

La couche de protection 7 sont réalisées dans un matériau choisi parmi AlF₃, SiN/SiC, Al₂O₃, HfAlₓO_{y}/SiO₂, AlN avec une implantation de F et ZrO₂.

La couche de protection 7 est réalisée lors l'élaboration de la tranchée d'isolation profonde. Les tranchées d'isolation profonde sont employées pour séparer physiquement des photodiodes arrangées en matrice ou une photodiode de son environnement immédiat. Pour cela, on réalise des tranchées dans le silicium dopé formant la première couche 2 et la deuxième couche 3, lors d'une étape initiale 9 d'un procédé de fabrication. Ces tranchées peuvent être réalisées par attaque humide, attaque physique de type reactive ion etching, ou ion beam milling.

Une fois la tranchée ouverte, un premier dépôt conforme est réalisé, lors d'une étape suivante 10 du procédé de fabrication, afin de créer la couche de protection 7. Pour cela, on dépose un matériau choisi parmi AlF₃, SiN/SiC, Al₂O₃, HfAlₓO_{y}/SiO₂, AlN avec implantation de F et ZrO₂. Le dépôt peut être réalisé par pulvérisation cathodique, par dépôt galvanique ou par toute autre méthode appropriée. Le dépôt conforme permet d'obtenir une épaisseur constante de matériau garantissant un effet constant sur toute la longueur de la tranchée d'isolation profonde. L'épaisseur obtenue est comprise entre 5nm et 20nm.

On réalise ensuite un dépôt d'isolant, tels que du dioxyde de silicium ou du nitrure de silicium, lors d'une étape suivante 11 du procédé de fabrication afin de combler la trancher et de lui conférer son caractère isolant. Des étapes ultérieures de procédé peuvent alors être réalisées, tel que la formation des électrodes de contact ou le dépôt de matériau antireflet.

L'élaboration de la deuxième couche dopée 3 est arrêtée lorsque l'épaisseur atteinte correspond à l'épaisseur de la partie située sous la couche de protection intermédiaire. On réalise alors le dépôt d'une couche du même matériau que le matériau utilisé pour obtenir la couche de protection 7. Lorsque l'épaisseur souhaitée est atteinte, l'élaboration de la deuxième couche dopée et plus généralement de la photodiode, peut reprendre.

Une photodiode comprenant des tranchées d'isolation profonde voit ses caractéristiques améliorées en insérant une couche de protection de façon qu'une zone de charge négative apparaisse à l'interface entre le silicium et la tranchée d'isolation profonde. De plus, une couche de protection intermédiaire peut permettre de créer une couche de charges négatives à une distance de la zone active supérieure à la distance entre la zone active et la zone de charge d'espace. En évitant la recombinaison des électrons photogénérés, la couche de protection intermédiaire permet d'améliorer le contraste, le courant d'obscurité, et l'intensité du courant photogénéré.

## Revendications

1. Photodiode comprenant une première couche dopée (2) et une deuxième couche dopée (3) présentant une face commune, au moins une tranchée d'isolation profonde (4) présentant une face contiguë avec la première couche dopée (2) et la deuxième couche dopée (3), une face libre de la deuxième couche dopée (3) étant en contact avec une couche conductrice (5),
**caractérisée en ce qu'**elle comprend une couche de protection (7) apte à générer une couche de charges négatives à l'interface avec d'une part la première couche dopée (2) et la deuxième couche dopée (3) et d'autre part la tranchée d'isolation profonde.

2. Photodiode selon la revendication 1, dans laquelle l'épaisseur de la couche de protection (7) est comprise entre 5nm et 20nm.

3. Photodiode selon l'une des revendications 1 et 2, dans laquelle la couche de protection (7) est réalisée dans un matériau choisi parmi AlF₃, SiN/SiC, Al₂O₃, HfAlₓO_{y}/SiO₂, AlN avec une implantation de F et ZrO₂.

4. Photodiode selon l'une quelconque des revendications 1 à 3, comprenant une couche intermédiaire de protection (8) située au moins en partie dans la deuxième couche dopée (3), ladite couche intermédiaire de protection (8) étant apte à générer une couche de charges négatives à l'interface avec la deuxième couche dopée (3).

5. Procédé de réalisation d'au moins une tranchée (4) d'isolation profonde, chaque tranchée (4) d'isolation profonde étant réalisée entre deux photodiodes réalisées à partir d'une structure comprenant une première couche dopée (2) et une deuxième couche dopée (3) présentant une face commune, une face libre de la deuxième couche dopée (3) étant en contact avec une couche conductrice (5), **caractérisé par le fait qu'**il comprend des étapes au cours desquelles :
on réalise une gravure d'au moins une tranchée (4) à travers la première couche dopée (2) et la deuxième couche dopée (3) jusqu'à la couche conductrice (5) ;
on dépose de façon conforme, dans la tranchée (4), une couche de protection (7) d'un matériau apte à créer une couche de charge négative à l'interface avec le silicium ; et
on dépose un isolant de façon conforme sur la couche de protection (7) jusqu'à remplissage de la tranchée.

6. Procédé selon la revendication 5, dans lequel on réalise la couche de protection (7) avec une épaisseur comprise entre 5nm et 20nm.

7. Procédé selon l'une des revendications 5 et 6, dans lequel on réalise la couche de protection (7) dans un matériau choisi parmi AlF₃, SiN/SiC, Al₂O₃, HfAlₓO_{y}/SiO₂, AlN avec une implantation de F et ZrO₂.
